# EUROPÄISCHE PATENTANMELDUNG

(11) **EP 0 584 658 A2**
(43) Veröffentlichungstag der Anmeldung: **02.03.1994**
(21) Anmeldenummer: 93112905.0
(22) Anmeldetag: 12.08.1993
(51) Int. Cl.: H04Q 1/14, H05K 9/00

(54) **Verteiler für EMV abgeschirmte Schränke**

(30) Priorität: 22.08.1992 DE 9211291 U
(71) Anmelder: Alcatel SEL Aktiengesellschaft, D-70435 Stuttgart (DE)
(72) Erfinder: Steffen, Guenter, D-71282 Hemmingen (DE)
(74) Vertreter: Knecht, Ulrich Karl

(57) **Zusammenfassung**

Bei einem in einem Schrank untergebrachten Verteiler (1) sind in einem in der Vertikalen offenen Baugruppenträger (2) lückenlos nebeneinander mehrere anreihbare Baugruppen (3) befestigt. Zur besseren Ausnutzung des Schrankvolumens und zur knickfreien Führung der Verkabelung haben die Baugruppen (3) eine pultartige Form mit schräg zur Vertikalen liegender Frontplatte (4). In der Frontplatte sind Steckkupplungen (5) für die Steckverbinder der von oben ankommenden externen Kabel (6) befestigt, die hinter der Frontplatte (4) mit den abgehenden, internen Leitungen verbunden sind.

## Beschreibung

Die Erfindung betrifft einen Verteiler für EMV abgeschirmte Schränke der im Oberbegriff des Anspruchs 1 näher bezeichneten Ausführung. Solche Verteiler werden insbesondere in der Nachrichtentechnik verwendet.

Ein Verteiler nach dem Oberbegriff des Anspruchs 1 ist aus der EP 0 487 802 A1 bekannt. Die hier verwendeten Baugruppen bestehen aus Schienen, die in einem Gehäuse mit Tür angeordnet sind, das seinerseits an der Rückwand eines EMV abgeschirmten Schrankes befestigt ist. Die Schienen haben U-Profil und werden durch Einhängen in Schlitze und zusätzliches Verriegeln an der Rückwand des Gehäuses vertikal nebeneinander fixiert. Sie bilden zusammen mit Rückwand und Bodenplatte des Gehäuses eine Abschirmwand, an die von vorn die externen Kabel mit Steckverbindern an komplementäre Kupplungen gesteckt werden, welche von hinten mit den internen Leitungen verbunden sind.

Der Erfindung liegt die Aufgabe zugrunde, einen Verteiler möglichst kleiner Bauhöhe für EMV abgeschirmte Schränke zu schaffen, der eine bessere Ausnutzung des Schrankvolumens gestattet. Diese Aufgabe wird erfindungsgemäβ mit den im Anspruch 1 angegebenen konstruktiven Merkmalen gelöst. Vorteilhafte Ausgestaltungen des Verteilers sind den Unteransprüchen zu entnehmen.

Durch die schräge Anordnung der Baugruppen-Frontplatte wird die angestrebte Verkürzung der Bauhöhe erzielt. Außerdem bietet die Lösung den Vorzug, daß die ankommenden und abgehenden Kabel knickfrei an den Verteiler herangeführt werden können. Weiterhin haben die Baugruppen einen modulartigen Aufbau, der eine kostengünstige Herstellung und Montage des Verteilers gestattet. Die Frontplatten der Baugruppen bilden somit nach der Montage des Verteilers eine elektromagnetisch wirksame Abschirmwand zwischen dem Innenraum des Schrankes und seiner äußeren Umgebung.

Die Erfindung wird anhand einer Zeichnung, in der mehrere Ausführungsbeispiele dargestellt sind, wie folgt näher beschrieben. In der Zeichnung zeigen:
- Fig. 1: einen Verteiler mit mehreren Baugruppen teilweise ausgeschnitten, in perspektivischer Ansicht;
- Fig. 2: ein Ausführungsbeispiel einer Baugruppe des Verteilers der Fig. 1 von der Rückseite, perspektivisch dargestellt;
- Fig. 3: ein weiteres Ausführungsbeispiel einer Baugruppe des Verteilers von der Rückseite, perspektivisch dargestellt.

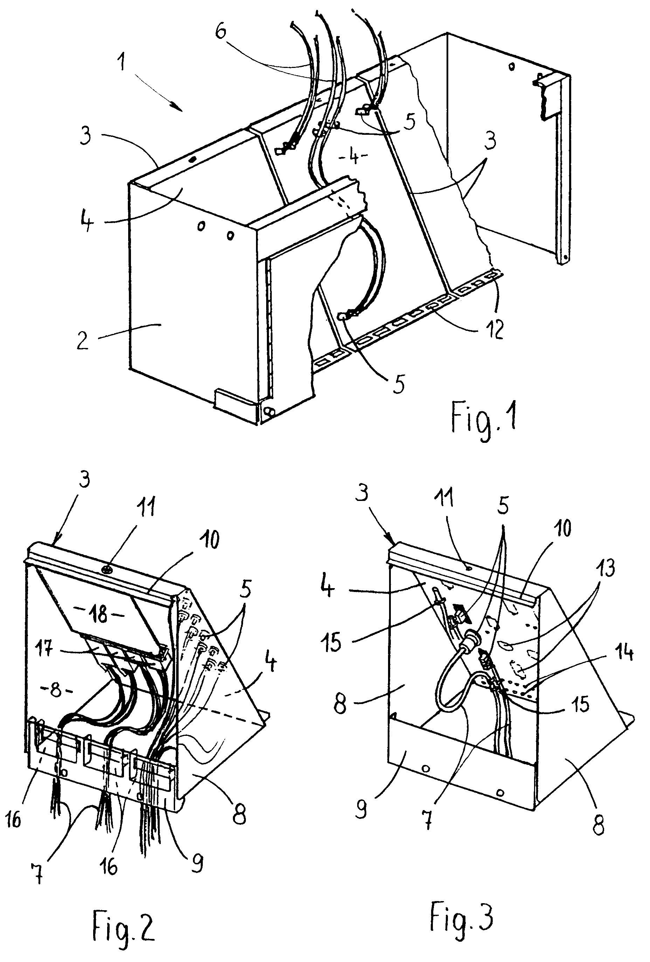

In Fig. 1 ist der Verteiler insgesamt mit 1 bezeichnet. Er besteht im wesentlichen aus einem kastenförmigen, in der Vertikalen offenen Baugruppenträger 2 mit mehreren, darin lückenlos nebeneinander angeordneten Baugruppen 3, die an Frontplatten 4 befestigte Verbindungs-Bauelemente 5 für den Anschluß von ankommenden, externen Kabeln 6 und von abgehenden, internen Leitungen 7 haben.

Der Baugruppenträger 2 ist aus einem nichtrostenden, magnetisch leitenden Stahlblech hergestellt. Die Abmessungen sind dabei so ausgelegt, daß er im oberen Teil eines Schrankes befestigt werden kann. Die Baugruppen 3 bestehen aus dem gleichen Stahlblech. Sie haben eine pultartige Form mit schräg zur Vertikalen liegender Frontplatte 4 und mit dreieckförmigen Seitenwänden 8 sowie einem die Seitenwände 8 am unteren Ende rückseitig miteinander verbindenden Blechstreifen 9 (Fig. 2 und 3). Das obere Ende der Frontplatte 4 geht in eine schmale, horizontal verlaufende Deckseite über, deren freies Ende an der Rückseite der Baugruppe 3 zu einer Halteschiene 10 abgewinkelt ist. Mit dieser Halteschiene 10 wird die Baugruppe 3 an der oberen Kante des Baugruppenträgers 2 eingehängt und der rückwärtige Blechstreifen 9 an den Baugruppenträger geschraubt. Außerdem enthält die Deckseite zur Herstellung einer individuellen Masseverbindung beispielsweise eine Gewindebohrung 11.

Das untere Ende der Frontplatte 4 mündet in einen vorgezogenen, horizontalen Blechlappen, der mehrere ausgestanzte Öffnungen mit eingehängten Kontaktfedern 12 für einen elektromagnetisch dichten Abschluß zum Deckblech des Schrankes hat. Die so gestaltete Baugruppe 3 ist an der Rückseite weitgehend und an der Unterseite vollkommen offen. In der Frontplatte 4 sind standardisierte Öffnungen 13 für die Befestigung der Verbindungs-Bauelemente 5, die nachfolgend nur kurz Verbinder genannt werden, enthalten. Die Verbinder 5 entsprechen den geläufigen Anschlußtechniken und sind beispielsweise für den Anschluß von Koaxialkabeln, gewöhnlichen Signalkabeln oder Glasfaserkabeln ausgebildet, die von außen und von innen gesteckt oder z.B. bei Signalleitungen innen an Stifte oder Fahnen gewickelt oder gelötet werden.

In der Frontplatte 4 können außerdem, vorzugsweise am unteren Ende, Löcher 14 zur rückseitigen Befestigung von Kabelhaltern 15 vorgesehen sein, mit denen die intern abgehenden Leitungen 7 einzeln fixiert und die zu den Verbindern 5 führenden Anschlüsse zugentlastet werden (Fig. 3). Bei dem in Fig. 2 dargestellten Ausführungsbeispiel sind dagegen auf der Innenseite des rückwärtigen Blechstreifens 9 Kabelhalter 16 befestigt, mit denen jeweils eine größere Anzahl Leitungen 7 gemeinsam fixiert sind. Natürlich können die dargestellten Kabelhalter 15, 16 und auch jede andere zweckmäßige Ausführung bedarfsweise an der Frontplatte 4 und/oder dem Blechstreifen 9 angebracht sein. Von den Leitungen 7 der Innenverkabelung gemäß Fig. 2 sind einige direkt an die Verbinder 5 der Frontplatte 4 angeschlossen, während andere über Stecker 17 mit den Anschlußkontakten einer in parallem Abstand hinter der Frontplatte 4 angeordneten, gedruckten Leiterplatte 18 verbunden sind. Auf der Leiterplatte 18 können Verbindungselemente befestigt sein, mit denen sie an die Verbinder 5 der Frontplatte 4 gesteckt ist oder die durch die Öffnungen 13 in der Frontplatte 4 ragen und den direkten Anschluß von komplementären Verbindungselementen der ankommenden Verkabelung gestatten.

## Patentansprüche

1. Verteiler für den elektrischen Anschluß von externen und internen Leitungen für EMV abgeschirmte Schränke der Nachrichtentechnik, der aus mehreren, lückenlos nebeneinander angeordneten Baugruppen besteht, die an der Rückwand einer im Schrank befestigbaren Aufnahme fixiert sowie an der Rück- und Unterseite offen sind und die an der Frontplatte befestigte Verbinder-Bauelemente für die Leitungen haben,
**dadurch gekennzeichnet,** daß die Aufnahme als oben und unten offener Baugruppenträger (2) ausgebildet ist und daß jede Baugruppe (3) eine pultartige Form mit schräg zur Vertikalen liegender Frontplatte (4) hat.

2. Verteiler nach Anspruch 1, dadurch gekennzeichnet, daß das obere Ende der Frontplatte (4) in eine horizontal verlaufende Deckseite übergeht, deren freies Ende an der Rückseite der Baugruppe (3) zu einer Halteschiene (10) abgewinkelt ist.

3. Verteiler nach Anspruch 1, dadurch gekennzeichnet, daß das untere Ende der Baugruppen-Frontplatte (4) einen horizontal vorgezogenen Blechlappen mit mehreren, in je eine Öffnung des Blechlappens eingehängten Kontaktfedern (12) hat.

4. Verteiler nach Anspruch 1, dadurch gekennzeichnet, daß die Baugruppe (3) rückseitig mit einem die Seitenwände (8) am unteren Ende miteinander verbindenden Blechstreifen (9) versehen ist.

5. Verteiler nach Anspruch 2 und 4, dadurch gekennzeichnet, daß die Baugruppe (3) durch Einhängen der oberen Halteschiene (10) in den Baugruppenträger (2) und Anschrauben des unteren Blechstreifens (9) am Baugruppenträger (2) befestigt ist.

6. Verteiler nach Anspruch 1 und 4, dadurch gekennzeichnet, daß an der Rückseite der Baugruppen-Frontplatte (4) und/oder der Innenseite des rückwärtigen Blechstreifens (9) mehrere Kabelhalter (15, 16) für die Fixierung der abgehenden Verkabelung (Leitungen 7) angebracht sind.
